# EUROPÄISCHE PATENTSCHRIFT

(11) **EP 0 705 475 B1**
(45) Veröffentlichungstag und Bekanntmachung des Hinweises auf die Patenterteilung: **16.04.1997**
(21) Anmeldenummer: 94916894.2
(22) Anmeldetag: 09.06.1994
(51) Int. Cl.: G11B 11/10

(54) **MAGNETOOPTISCHES SPEICHERSCHICHTSYSTEM, MAGNETOOPTISCHES SPEICHERSYSTEM UND SCHREIBVERFAHREN**
RECORDING SYSTEM WITH MAGNETO-OPTIC LAYERS, MAGNETO-OPTIC RECORDING SYSTEM AND WRITING PROCESS
SYSTEME D'ENREGISTREMENT A COUCHES MAGNETO-OPTIQUES, SYSTEME D'ENREGISTREMENT MAGNETO-OPTIQUE ET PROCEDE D'ECRITURE

(30) Priorität: 22.06.1993 DE 4320514
(43) Veröffentlichungstag der Anmeldung: 10.04.1996
(73) Patentinhaber: FORSCHUNGSZENTRUM JÜLICH GMBH, 52425 Jülich (DE)
(72) Erfinder: DEMOKRITOV, Serguei, D-52428 Jülich (DE); GRÜNBERG, Peter, D-52428 Jülich (DE); ZINN, Werner, verstorben (DE)
(86) Internationale Anmeldenummer: DE9400646
(87) Internationale Veröffentlichungsnummer: WO9500950

(56) Entgegenhaltungen:
- EP-A- 0 319 004
- EP-A- 0 369 815
- EP-A- 0 470 862
- IBM TECHNICAL DISCLOSURE BULLETIN., Bd.33, Nr.8, Januar 1991, NEW YORK US Seiten 390 - 391, XP000109231 'Exchange coupled amorphous Uranium Antimonide magneto-optic materials'
- IBM TECHNICAL DISCLOSURE BULLETIN., Bd.8, Nr.2, Juni 1965, NEW YORK US Seiten 291 - 292 'Magnetic recording with laser beams'
- IBM TECHNICAL DISCLOSURE BULLETIN., Bd.11, Nr.6, November 1968, NEW YORK US Seiten 613 - 614 'Composite film Curie temperature keeper'
- IBM TECHNICAL DISCLOSURE BULLETIN., Bd.32, Nr.4A, September 1989, NEW YORK US Seiten 384 - 386 'Thermomagnetic recording medium for a direct overwrite recording system'
- PHYSICA B & C, Bd.89B+C, April 1977, NETHERLANDS Seiten 63 - 66 HELTEN ET AL. 'Optical investigations of Eu rich EuO near the absorption edge'
- PHYSICA B & C, Bd.89B+C, April 1977, NETHERLANDS Seiten 225 - 228 GRÜNBERG ET AL. 'Raman scattering and photon dispertion of Europium monochalcogenides'
- PATENT ABSTRACTS OF JAPAN vol. 15, no. 24 (P-1156) 21. Januar 1991 & JP,A,02 267 754 (SHARP K.K.) 1. November 1990
- PATENT ABSTRACTS OF JAPAN vol. 13, no. 357 (P-915) 10. August 1989 & JP,A,01 116 942 (AGENCY OF IND SCIENCE & TECHNOLOGY) 9. Mai 1989

## Beschreibung

Die Erfindung bezieht sich auf ein magnetooptisches Speicherschichtsystem mit magnetischer Schicht als Speicherschicht für digitale Information. Sie bezieht sich ferner auf ein magnetooptisches Speichersystem mit Lichtquelle, Fokussystem und Speicherschicht und ein entsprechendes Schreibverfahren.

Es ist heute üblich, "bits" thermomagnetisch in amorphe, chemisch metastabile ferrimagnetische Schichten (Dicke typischerweise 50 nm) einzuschreiben, die aus speziell zusammengesetzten Legierungen (Seltenen Erden (Gd, Tb) und Übergangsmetallen (Fe, Co)) bestehen. Bei dieser bekannten Verfahrensweise wird die "bit"-Fläche im Laserfokus bei Anliegen eines magnetischen Feldes (Schreibfeld H_{S}) bei jedem Schreibvorgang 100 - 150 K bis an die Curietemperatur der Speicherschicht aufgeheizt. Das Auslesen erfolgt dann mit Hilfe des magnetischoptischen Kerr-Effektes.

Es ist Aufgabe der Erfindung, dieses bekannte Schreibverfahren, bei dem lokale Aufheizung bei jedem Schreibvorgang stattfinden muß, dadurch zu ersetzen, daß ein neues magnetooptisches Speicherschichtsystem und damit ein magnetooptisches Speichersystem geschaffen wird, mit dem ein Einschreiben der "bits" ohne Aufheizen und, falls zweckmäßig, auch ohne Schreibfeld möglich ist.

Die der Erfindung zugrundeliegende Aufgabe wird durch ein magnetooptisches Speicherschichtsystem gelöst, bei dem zwei oder drei ferromagnetische Schichten (FM 1, FM 2, FM 3) mit jeweils dazwischen befindlicher halbleitender Schicht (HL, HLₐ, HL_{b}) vorgesehen sind. Dabei sind die ferromagnetischen Schichten unterschiedlich hart magnetisiert und Dicke und Energielücke der halbleitenden Schichten sind so bemessen, daß mit einem fokussierten Strahl einer Lichtquelle geeigneter Intensität und Wellenlänge eine hinreichende Zahl von lichtinduziert angeregten Elektronen in die bis dahin leeren Leitungsbandzustände des Halbleiters angeregt werden. Dadurch wird zwischen den benachbarten ferromagnetischen Schichten eine ohne Licht nicht vorhandene RKKY-artige Zwischenschichtkopplung bewirkt, die zu einer Speicherung oder Löschung der Information in einer der ferromagnetischen Schichten führt.

Die Grundidee des erfindungsgemäßen magnetooptischen Speicherschichtsystems beruht auf der in "Grünberg, P., Phys. Bl. 49 (1993), S. 27-30 (Review), Phys. Rev. Letters 57 (1986) 2442" in Verbindung mit einem metallischen Fe/Cr/Fe-Doppelschichtsystem beschriebenen Zwischenschichtaustauschkopplung, die je nach Dicke und Ladungsträgerdichte in der Zwischenschicht zur ferrooder antiferromagnetischen Ausrichtung der beiden Fe-Schichten führt.

Für das erfindungsgemäße Speicherschichtsystem eignen sich einkristalline (z.B. epitaktisch auf Einkristallsubstraten hergestellte) oder auch polykristalline, auf geeigneten anderen Speicherplattensubstraten aufgedampfte oder "aufgesputterte", magnetisch koppelfähige Mehrfachschichtsysteme.

Die ferromagnetischen Schichten werden auf geeigneten Substraten durch VAriation der Herstellungsparameter (Substrattemperatur, -rauhigkeit, Wachstumsrate und Schichtdicke) so präpariert, daß ihre Koerzitivfeldstärken H_{c1}, H_{c2}, H_{c3} hinreichend verschieden eingestellt sind. Durch Ummagnetisierung der weichmagnetischen Schicht in einem zwischen H_{c1} und H_{c2(3)} liegenden äußeren Magnetfeld kann auf diese Weise ein definierter Anfangszustand (genannt "Löschzustand") der beiden ferromagnetischen Schichten eingestellt werden, der sich durch parallele oder antiparallele Magnetisierung beider Schichten auszeichnet.

Die ferromagnetischen Schichten werden für die gewünschte chemische Langzeitstabilität bevorzugt aus reinen 3d-Metallen (Fe, Co, Ni) oder deren thermodynamisch stabilen Legierungen (z.B. Fe-Ni oder Co-Ni oder Ni(81)Fe(19) "Permalloy") zur Ausnutzung von Grenzflächeneffekten auch in Form fein geschichteter ferromagnetischer Multischichten hergestellt. Ihre magnetischen Anisotropie- und Koerzitivfeldstärken lassen sich dabei durch Wahl der Schichtdicken, Zusammensetzungen und Grenzflächenbeschaffenheit bei den chemischen und physikalischen Schichtherstellungsverfahren in weiten Grenzen einstellen. (Die Langzeitstabilität ist bei den bisher benutzten amorphen (Gd, Tb)(Fe,Co)-Schichten bekanntlich ein trotz der AlN-Versiegelungsschichten immer noch ernstes und ungelöstes Problem).

Das erfindungsgemäße Speicherschichtsystem ist aus chemisch stabilen ferromagnetischen Schichten und einer für die Zwischenschichtaustauschkopplung durch Ladungsträgerspinpolarisation (RKKY-Austausch) geeigneten, halbleitenden Schicht mit ebenfalls chemisch und thermodynamisch stabilen Eigenschaften aufgebaut. Die Ummagnetisierung der "bit"-Fläche im Laserfokus wird nun nicht durch thermisches Aufheizen zum Curiepunkt bei Anliegen eines äußeren Schreibfeldes wie bisher bewirkt, sondern durch lokale Erzeugung von lichtinduziert angeregten Elektronen im Leitungsband des Halbleiters, die über die Intensität des Laserstrahls so bemessen und kontrolliert wird, daß die lokal entstehende Leitungselektronendichte die RKKY-Zwischenschichtaustauschkopplung mit dem für die jeweilige Ummagnetisierung gewünschten Vorzeichen erzeugt. So kann man das gewünschte "bit" (typischerweise eine kreisförmige Domäne von etwa 1 µm Durchmesser) ohne Zuhilfenahme eines äußeren Schreibfeldes mit dem Licht/Laserstrahl in die weichmagnetischere ferromagnetische Schicht, die Speicherschicht, einschreiben.

Liegt ein Speicherschichtsystem mit zwei ferromagnetischen Schichten und einer halbleitenden Zwischenschicht vor, ist zweckmäßigerweise die obere der beiden Schichten die weichmagnetische. Bei Verwendung einer geeigneten Halbleiterzwischenschicht mit zunächst leerem Leitungsband wird die Zwischenschichtkopplung zunächst auf Null gesetzt. Die weichmagnetische Speicherschicht mit dem kleineren H_{c}, die Speicherschicht, wird im Ausgangszustand in einem äußeren Magnetfeld beispielsweise antiparallel zur unteren, hartmagnetischen ferromagnetischen Schicht, der Referenzschicht, magnetisiert (entspricht der Magnetisierung der "0"-bits). Ein parallel zur Referenzschicht magnetisiertes "bit" (entspricht der "1") in der darüberliegenden Speicherschicht wird nun allein durch optische Aktivierung der Zwischenschichtkopplung eingeschrieben. Dazu erzeugt man durch einen Lichtblitz (Laserblitz) geeigneter Intensität I(+) und Wellenlänge kurzzeitig die für ferromagnetische Zwischenschichtkopplung erforderliche Leitungselektronendichte, und zwar durch Photoemission von Elektronen aus den besetzten Bandzuständen der Halbleiterschicht in die leeren Leitungsbandzustände. Mit einer davon deutlich verschiedenen Laserintensität I(-) kann man entsprechend eine größere oder kleinere Ladungsträgerdichte erzeugen, die dann zur antiferromagnetischen Austauschkopplung zwischen der Referenz- und der Speicherschicht führt. Auf diese Weise kann man eine vorher mit I(+) eingeschriebene "1" wieder löschen, also in die "0"-Magnetisierungsgrundrichtung der Speicherschicht zurückdrehen.

Liegt ein Speicherschichtsystem mit drei ferromagnetischen Schichten und zwei halbleitenden Zwischenschichten vor, dann hat man die Möglichkeit zu einer weiteren Selektionsmöglichkeit für die Wahl von Vorzeichen und Stärke des Licht(Laser)-induzierten Schreibvorgangs. In diesem Fall ist die weichmagnetische ferromagnetische Schicht, die Speicherschicht, zweckmäßigerweise die mittlere der drei Schichten. Diese ist mit zwei unterschiedlichen Halbleiterschichten an die beiden anderen ferromagnetischen Schichten, die Referenzschichten, gekoppelt. Benutzt man nun zwei unterschiedliche Licht(Laser)-Frequenzen zum Aktivieren der Zwischenschichtkopplung zur oberen Referenzschicht und zur unteren Referenzschicht, so kann man den Schreibprozeß für die "1" und für die "0" (löschen) völlig entkoppeln und damit getrennt optimieren. In diesem Falle werden allerdings in der Regel zwei Lichtquellen bzw. zwei Laser benötigt.

Aus dem Gesagten geht hervor, daß die Schichten optisch transparent bzw. deren Dicke so bemessen sein muß, daß sie unterhalb der Eindringtiefe des einfallenden Lichtes liegt. Dies ist im Regelfall dann der Fall, wenn die Gesamtdicke der zwei oder - im Falle des drei ferromagnetische Schichten aufweisenden Schichtsystems - der drei oberen Schichten nicht größer als 20 nm ist.

Zweckmäßig ist ferner, daß die oberste der ferromagnetischen Schichten dünner als die darunterliegenden ist.

Die Halbleiterschichten, deren Dicke zwischen 0,5 bis 5 nm bzw. zwischen 1 und 100 atomaren Lagen liegt, bestehen zweckmäßigerweise aus III/V-Halbleiter (z.B. GaAs) und II/VI-Halbleiter (z.B. PbTe). Neben den für epitaktische Schichten mit Fe-Schichten günstigen GaAs-Schichten eignen sich besonders Schichten der magnetischen Halbleitergruppe EuX (mit X = O, S, Se, Te). Diese sind, wie beispielsweise aus "Köhne, F.J., N. Rasula, B. Saftic, W. Zinn, Journal de Phys. C5, Supp. 6, 41 (1980), 127-129" und "Zinn, W., B. Saftic, N. Rasula, M. Mirabal, J. Köhne, Journal Magn. Mag. Mat. 35 (1983) 329-336" entnehmbar ist, durch Wahl der Aufdampfapparatur mit gewünschter Stöchiometrie EuₓX_{y} herstellbar, bis hin beispielsweise zu perfekten EuS-Einkristallen auf Siliciumwafern mit X = Y = 1.

Die vorgenannten Verbindungshalbleiter lassen durch Variation der chemischen Zusammensetzung oder durch geeignete Dotierung mit anderswertigen Ionen (Donatoren) die Einstellung der Energielücke < E_{g} > oder der Donator Aktivierungsenergie E_{D} in weiten Grenzen zu. Dies kann zum Anpassen der Aktivierungsenergie für den lichtinduzierten Anregungsprozeß an die Wellenlängen der für die erforderlichen Intensitäten verfügbaren Lichtquellen bzw. Laser, insbesondere an die derzeit für magnetooptische Speicherung in den Schreib- und Leseköpfen eingesetzten Halbleiter-Laserdioden erforderlich sein.

Zur Erzeugung von Donatorzuständen an geeigneter Stelle in der Energielücke < E_{g} >, d.h. mit einer Donatoraktivierungsenergie E_{d} < E_{g}, kann man entweder unstöchiometrische Schichten mit Fehlstellen im Eu-Kation oder X-Anionen-Gitter herstellen oder mit andersartigen Ionen auf einem der Untergitter substituieren, z.B. Eu²⁺ mit SE³⁺-Ionen wie Gd³⁺ oder La³⁺. Damit kann man die Aktivierungsenergie E_{D} der Donatorzustände an die Wellenlänge der Halbleiter-Laser-Dioden des Schreibsystems anpassen.

Andererseits kann durch die Donatorkonzentration und damit der innerhalb des Licht(Laser)-Fokusses verfügbaren Gesamtzahl N_{D} der Donatoren, eine Sättigungszahl von anregbaren Photoelektronen vorgegeben werden. Auf diese Weise lassen sich die Stärke und das Vorzeichen der damit aktivierten Zwischenschichtkopplung zusätzlich durch die Schichtpräparation kontrollieren.

Zum Schutz des Speicherschichtsystems ist dieses zweckmäßigerweise mit einer optisch transparenten Schutzschicht, beispielsweise aus AlN, bedeckt.

Die der Erfindung zugrundeliegende Aufgabe wird, wie sich aus den vorherigen Ausführungen bereits ergibt, im Hinblick auf das magnetooptische Speichersystem durch ein Speichersystem mit den Merkmalen des Anspruchs 9 gelöst.

Eine Weiterausgestaltung dieses erfindungsgemäßen Speichersystems besteht darin, daß zusätzlich eine Einrichtung für ein senkrecht zur Schichtenebene verlaufendes Magnetfeld (H_{S}) vorgesehen ist, dessen Feldstärke so bemessen ist, daß sie zwischen den Koerzitivfeldstärken (H_{c1} und H_{c2}) der zu koppelnden ferromagnetischen Schichten liegt.

Die Richtung des äußeren Schreibfeldes H_{S} steht senkrecht zur Schichtenebene und ist mit dem Licht(Laser)-Schreibkopf integriert. Da die Schreibfeldstärke H_{S} so gewählt ist, daß sie zwischen den Koerzitivfeldstärken H_{c1} und H_{c2} der zu koppelnden ferromagnetischen Schichten liegt, wird gewährleistet, daß beim Schreibvorgang die weichmagnetische Schicht (FM 2) mit dem kleineren H_{c} nun vom Schreibfeld H_{S} stets in Feldrichtung gehalten wird. Sie wird damit hier von der Speicher- zur Referenzschicht, während die Informationen "0" und "1" nun in die härtermagnetische Schicht eingeschrieben wird. Dies kann für die Speicherdichte (stabile Minimalgröße der "bit" Domänen in der jeweiligen Speicherschicht) und für die Langzeitstabilität der gespeicherten Information vorteilhaft sein. Zum Schreiben einer entgegengesetzt magnetisierten "1" in der Speicherschicht durch Einschalten der photoelektrisch aktivierten Zwischenschichtkopplung A₁₂ zwischen der Speicher- und Referenzschicht muß die zugehörige Kopplungsfeldstärke H₁₂ = A₁₂/(µ₀M₁d₁) in Richtung von H_{S} liegen und betragsmäßig in der Summme H_{S} + H₁₂ größer sein als H_{c1} (M₁ ist die Magnetisierung der Schicht FM₁). Zum Einschreiben einer "0", bzw. zu Löschen der "1", kehrt man - genau wie beim thermomagnetischen Schreiben mit einem analog aufgebauten Schreibkopf - nun einfach die Schreibfeldrichtung H_{S}, also die Magnetisierungsrichtung der weichmagnetischen Referenzschicht (FM 2), um.

Die der Erfindung zugrundeliegende Aufgabe wird ferner durch ein magnetooptisches Schreibverfahren gelöst, bei dem das erfindungsgemäße Speichersystem Verwendung findet und das sich dadurch auszeichnet, daß der auf eine halbleitende Schicht fokussierte Licht(Laser)-Blitz eine Zeitdauer von 10⁻⁹ s nicht überschreitet. Im Gegensatz dazu benötigt das derzeitige thermomagnetische Schreibverfahren für das Aufbauen eines im lokalen Laserfokusbereich um 100 - 150°C heißeren Temperaturprofils eine wesentlich längere Zeit.

Eine Weiterausgestaltung des erfindungsgemäßen Schreibverfahrens mit zusätzlicher Kontrolle der Zwischenschichtaustauschkopplung erhält man bei Verwendung ferromagnetischer Halbleiterschichten aus EuX-Materialien mit einem spinpolarisierten Eu-4f-Band durch die Tatsache, daß dann durch die f-s, f-d und f-p Austauschwechselwirkungen im EuX-System und ferner an der (FM/HL)-Grenzfläche, z.B. (Fe/EuX) durch die entstehenden Wechselwirkungen mit dem spinpolarisierten 3d-Band der ferromagnetischen Fe-Schichten, alle diese Donator- und Leitungsbandzustände des Halbleiters, die durch Photoanregung besetzt werden können, ebenfalls magnetisch aufgespalten sind. Damit ist die Möglichkeit gegeben, bei kleinerer Laserintensität I(+) zunächst nur das untere Spinhalbband der Leitungselektronenzustände mit Photoelektronen zu besetzen. Dadurch ergibt sich eine weitere Möglichkeit zur Festlegung des Vorzeichens der Zwischenschichtkopplung und damit des Einschreibemodus ("0" oder "1").

In der Zeichnung sind Speicherschichtsysteme bzw. Speichersysteme schematisch dargestellt. Sie werden im einzelnen nachfolgend näher erläutert.

Es zeigen:
- Figur 1: ein Speichersystem mit zwei ferromagnetischen Schichten und einer dazwischen befindlichen halbleitenden Schicht;
- Figur 2: ein Speichersystem mit drei ferromagnetischen Schichten und zwei dazwischenliegenden Halbleiterschichten;
- Figur 3: ein Speichersystem mit zwei ferromagnetischen Schichten und einer Halbleiterschicht mit zusätzlichem äußeren magnetischen Schreibfeld H_{S}.

Es wird im folgenden davon ausgegangen, daß bei den in der Zeichnung dargestellten Fällen das Material der Schichten, Schichtdicken, Energielücken der Halbleiterschichten sowie Intensitäten und Wellenlängen der Laser so gewählt sind, daß es beim Laserblitz zu der erwünschten Zwischenschichtkopplung zwischen benachbarten ferromagnetischen Schichten kommt.

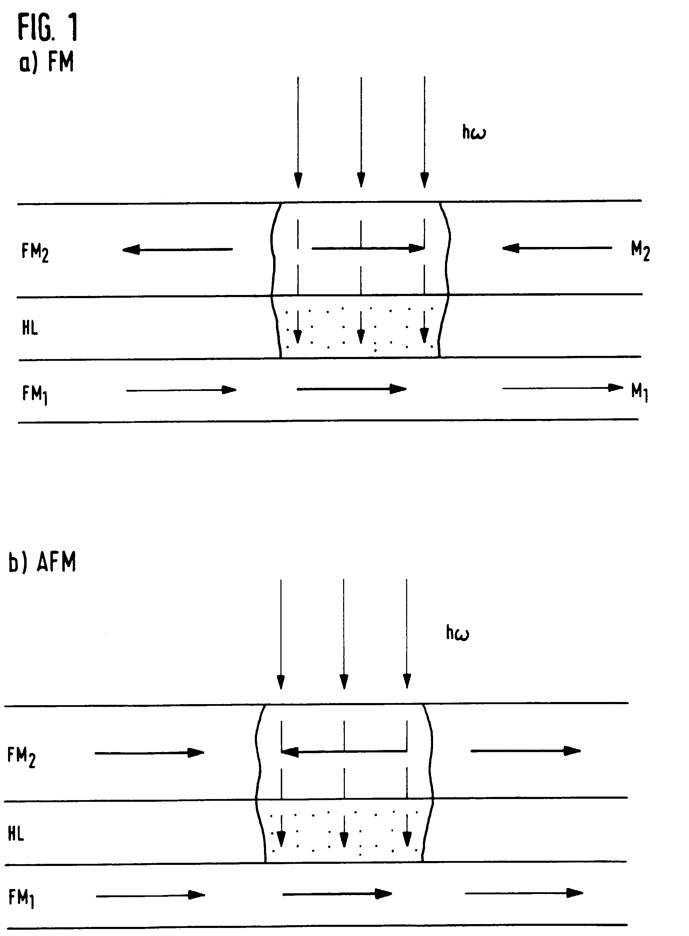

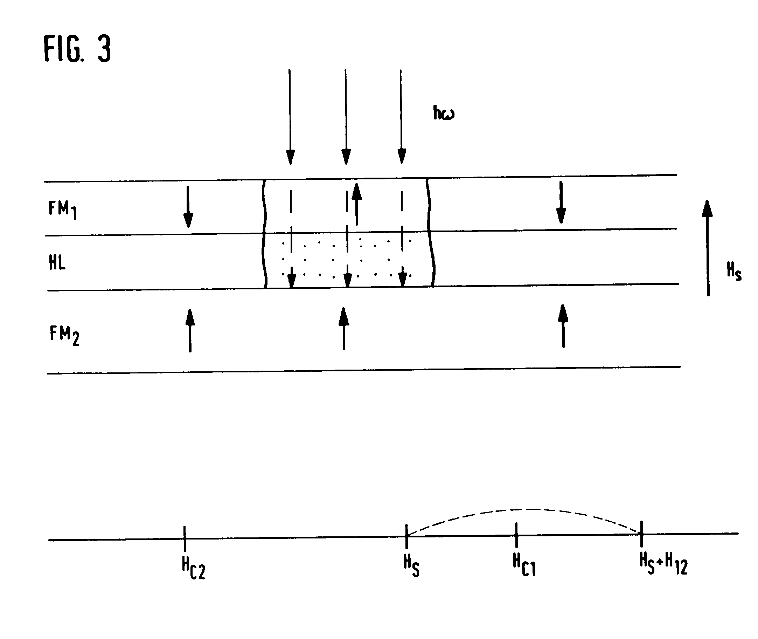

Bei dem in Abb. 1 dargestellten Fall wird die obere der ferromagnetischen Schichten FM₂ mit der Magnetisierung M₂ als die weichmagnetische, die untere Schicht FM₁ mit der Magnetisierung M₁ als die hartmagnetische angenommen.

Im Fall a) wird im Grundzustand der Schichten, der dem gelöschten Zustand entspricht, eine antiferromagnetische, also antiparallele Ausrichtung der beiden ferromagnetischen Schichten angenommen. Beim Laserblitz h, der durch die nach unten weisenden Pfeile angedeutet ist, wird in einem diesem Laserfokus entsprechenden Bereich durch ferromagnetische Kopplung zwischen den beiden ferromagnetischen Schichten ein Einschreiben der Information in die obere Schicht bewirkt. Ein Laserblitz mit entsprechend veränderter Intensität soll ein Kopplungsfeld mit umgekehrten Vorzeichen erzeugen und zur Löschung der Information führen.

Im Falle b) wird im Grundzustand eine ferromagnetische Kopplung zwischen den beiden ferromagnetischen Schichten angenommen. Durch antiferromagnetische Kopplung beim Laserblitz wird die Information in die obere der Schichten eingeschrieben und kann durch einen entsprechenden Laserblitz geänderter Intensität und dem zugehörigen Kopplungsfeld umgekehrten Vorzeichens wieder gelöscht werden.

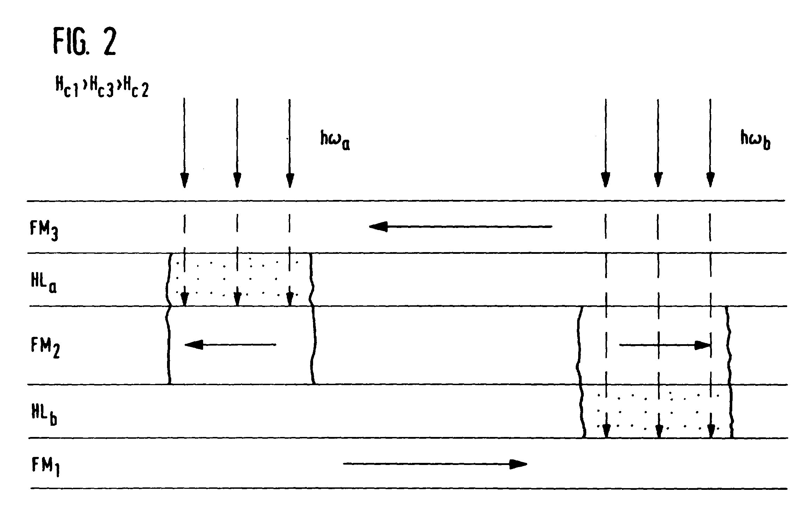

Die drei ferromagnetischen Schichten der Abb. 2 sind mit unterschiedlichen Koerzitivfeldstärken hergestellt, wobei H_{c1} > H_{c3} > H_{c2}, d.h., die mittlere der Schichten FM 2 ist die weichmagnetische, in der die Information eingeschrieben wird. Im dargestellten Fall sind die Schichten FM 1 und FM 3 antiferromagnetisch ausgerichtet. Einschreibe- und Löschvorgang werden nun mittels zweier Laser getrennt bewirkt, wobei es von der Ausrichtung der mittleren Schicht abhängt, durch welchen Laser (hₐ oder h_{b}) die Information eingeschrieben und gelöscht wird.

Nimmt man beispielsweise eine parallele Ausrichtung der beiden Schichten FM 2 und FM 1 an (antiparallel zur Schicht FM 3), so wird durch den Laserblitz hₐ durch ferromagnetische Zwischenschichtkopplung der Schichten FM 2 und FM 3 die Information eingeschrieben. Durch den Laserblitz h_{b} wird auf die gleiche Weise, nun durch die lichtinduzierte ferromagnetische Kopplung zwischen den Schichten FM₁ und FM₂, das "bit" wieder gelöscht.

Zu dem in Abb. 3 dargestellten, aus zwei ferromagnetischen Schichten mit dazwischenliegender Halbleiterschicht bestehenden Schichtsysstem ist die untere Schicht FM 2 mit der kleineren Koerzitivfeldstärke H_{c2} hergestellt und damit die weichmagnetischere Schicht. Dennoch wird in diesem Falle die Information in die hartmagnetischere Schicht FM 1 eingeschrieben. Dies geschieht mit Hilfe des konstant angelegten äußeren Magnetfeldes H_{S}, das sich der Magnetfeldstärke der unteren Schicht FM 2 überlagert und beim Laserblitz zur Ummagnetisierung im Laserblitz-Bereich führt. Mit dem gleichen Laserblitz, aber einem Schreibfeld H_{S} umgekehrten Vorzeichens kann die Information wieder gelöscht werden.

## Patentansprüche

1. Magnetooptisches Speicherschichtsystem mit magnetischer Schicht als Speicherschicht für digitale Information,
**dadurch gekennzeichnet,**
daß zwei oder drei ferromagnetische Schichten (FM 1, FM 2, FM 3) mit jeweils dazwischen befindlicher halbleitender Schicht (HL, HLₐ, HL_{b}) vorgesehen sind, wobei die ferromagnetischen Schichten unterschiedlich hart magnetisiert sind und Dicke und Energielücke der halbleitenden Schichten so bemessen sind, daß mit einem fokussierten Strahl einer Lichtquelle geeigneter Intensität und Wellenlänge eine hinreichende Zahl von lichtinduziert angeregten Elektronen in die bis dahin leeren Leitungsbandzustände des Halbleiters angeregt werden, wodurch zwischen den benachbarten ferromagnetischen Schichten eine ohne Licht nicht vorhandene RKKY-artige Zwischenschichtkopplung bewirkt wird, die zu einer Speicherung oder Löschung der Information in einer der ferromagnetischen Schichten führt.

2. Magnetooptisches Speicherschichtsystem nach Anspruch 1,
**dadurch gekennzeichnet,**
daß für den Fall, daß das Schichtsystem zwei ferromagnetische Schichten aufweist, die obere Schicht weichmagnetischer ist als die untere Schicht.

3. Magnetooptisches Speicherschichtsystem nach einem der Ansprüche 1 und 2,
**dadurch gekennzeichnet,**
daß für den Fall, daß das Schichtsystem drei ferromagnetische Schichten aufweist, die mittlere der Schichten weicher magnetisiert ist als die beiden anderen ferromagnetischen Schichten.

4. Magnetooptisches Speicherschichtsystem nach einem der Ansprüche 1 bis 3,
**dadurch gekennzeichnet,**
daß die Gesamtdicke der zwei oder - im Fall des drei ferromagnetische Schichten aufweisenden Schichtsystems - der drei oberen Schichten nicht größer als 20 nm ist.

5. Magnetooptisches Speicherschichtsystem nach einem der Ansprüche 1 bis 4,
**dadurch gekennzeichnet,**
daß die oberste ferromagnetische Schicht dünner als die darunter befindliche ist.

6. Magnetooptisches Speicherschichtsystem nach einem der Ansprüche 1 bis 5,
**dadurch gekennzeichnet,**
daß die Dicke der Halbleiterschicht 0,5 - 5 nm beträgt.

7. Magnetooptisches Speicherschichtsystem nach einem der Ansprüche 1 bis 6,
**dadurch gekennzeichnet,**
daß die Halbleiterschichten aus Material der magnetischen Halbleitergruppe EuX (mit X = 0, S, Se, Te) besteht.

8. Magnetooptisches Speicherschichtsystem nach einem der Ansprüche 1 bis 7,
**dadurch gekennzeichnet,**
daß der Halbleiter zur Erzeugung der vorgegebenen Energielücke mit Donatoren dotiert ist.

9. Magnetooptisches Speichersystem mit Schreibkopf und Lichtquelle, Fokussystem und Speicherschicht,
**gekennzeichnet durch**
ein magnetooptisches Speicherschichtsystem gemäß einem der Ansprüche 1, 2 und 4 bis 8, bestehend aus zwei ferromagnetischen Schichten mit Zwischenschicht, und einer Lichtquelle, die auf die Zwischenschicht fokussiert ist und deren Intensität und Wellenlänge so einstellbar sind, daß bei einer Intensität I(+) die Leitungselektronendichte einer Zwischenschichtkopplung mit dem zum Schreiben der "1"zutreffenden Vorzeichen besitzt und bei einer Intensität I(-) das entgegengesetzte Vorzeichen der Kopplung zum Schreiben der "O"-bits bzw. zum Löschen der Information bewirkt wird.

10. Magnetooptisches Speichersystem gemäß Anspruch 9,
**dadurch gekennzeichnet,**
daß zusätzlich eine Einrichtung für ein senkrecht zur Schichtenebene verlaufendes Magnetfeld (H_{S}) vorgesehen ist, dessen Feldstärke so bemessen ist, daß sie zwischen den Koerzitivfeldstärken (H_{c1} und H_{c2}) der zu koppelnden ferromagnetischen Schichten liegt.

11. Magnetooptisches Speichersystem mit Schreibkopf und Lichtquelle, Fokussystem und Speicherschicht,
**gekennzeichnet durch**
ein magnetooptisches Speicherschichtsystem gemäß einem der Ansprüche 3 bis 8, bestehend aus drei ferromagnetischen Schichten mit jeweils dazwischen befindlicher halbleitender Schicht, und zwei Lichtquellen, wobei die eine auf die eine Zwischenschicht und die andere auf die andere Zwischenschicht fokussiert ist und Intensität und Wellenlänge der einen Lichtquelle so einstellbar sind, daß die Leitungselektronen der betreffenden Halbleiterschicht unter Ausnutzung einer der beiden ferromagnetischen Schichten als Referenzschicht über die Zwischenschichtkopplung Informationen in die mittlere ferromagnetische Schicht einschreiben und Intensität und Wellenlänge der anderen Lichtquelle so einstellbar sind, daß die Leitungselektronen der betreffenden Halbleiterschicht unter Ausnutzung der anderen ferromagnetischen Schicht als Referenzschicht über die Zwischenschichtkopplung in die Zwischenschicht eingeschriebene Informationen wieder löscht.

12. Magnetooptisches Schreibverfahren, bei dem das magnetooptische Speichersystem gemäß einem der Ansprüche 9 bis 11 verwendet und ein Licht(Laser)-Blitz zum Einschreiben oder Löschen von Informationen eingesetzt wird,
**dadurch gekennzeichnet,**
daß der auf eine halbleitende Schicht fokussierte Licht(Laser)-Blitz eine Zeitdauer von 10⁻⁹ s nicht überschreitet.

13. Magnetooptisches Schreibverfahren nach Anspruch 12 unter Verwendung eines Speicherschichtsystems gemäß Anspruch 7,
**dadurch gekennzeichnet,**
daß ein Licht(Laser)-Blitz einer solchen Intensität eingesetzt wird, daß zur Festlegung des Vorzeichens der Zwischenschichtkopplung und damit des Einschreibmodus das untere Spinhalbband der Leitungselektronenzustände mit Photoelektronen besetzt wird.

## Claims

1. A magneto-optical storage layer system having a magnetic layer as a storage layer for digital information,
characterised in that
two or three ferromagnetic layers (FM 1, FM 2, FM 3) are provided, with a semiconducting layer (HL, HLₐ, HL_{b}) situated therebetween in each case, wherein the ferromagnetic layers are magnetised with different degrees of hard magnetisation, and the thickness and energy gap of the semiconducting layers are dimensioned so that with a focused beam from a light source of suitable intensity and wavelength a sufficient number of light-induced excited electrons are excited into the conduction band states, which were hitherto empty, of the semiconductor, whereby an RKKY-like intermediate layer coupling, which is not present without light, is effected between the adjacent ferromagnetic layers, and results in the storage or deletion of information in one of the ferromagnetic layers.

2. A magneto-optical storage layer system according to claim 1,
characterised in that
if the layer system comprises two ferromagnetic layers, the upper layer comprises a softer magnetism than the lower layer.

3. A magneto-optical storage layer system according to either one of claims 1 and 2,
characterised in that
if the layer system comprises three ferromagnetic layers, the middle one of the layers is magnetised more softly than are the two other ferromagnetic layers.

4. A magneto-optical storage layer system according to any one of claims 1 to 3,
characterised in that
the total thickness of the two - or in the case of the layer system comprising three ferromagnetic layers - of the three upper layers, is not greater than 20 nm.

5. A magneto-optical storage layer system according to any one of claims 1 to 4,
characterised in that
the uppermost ferromagnetic layer is thinner than those situated underneath it.

6. A magneto-optical storage layer system according to any one of claims 1 to 5,
characterised in that
the thickness of the semiconductor layer is 0.5 - 5 nm.

7. A magneto-optical storage layer system according to any one of claims 1 to 6,
characterised in that
the semiconductor layers consist of material from the magnetic semiconductor group EuX (where X = O, S, Se, Te).

8. A magneto-optical storage layer system according to any one of claims I to 7,
characterised in that
the semiconductor is doped with donors for the production of the predetermined energy gap.

9. A magneto-optical storage system having a write head and a light source, a focus system and a storage layer,
characterised by
a magneto-optical storage layer system according to any one of claims 1, 2 and 4 to 8, consisting of two ferromagnetic layers with an intermediate layer, and of a light source which is focused on the intermediate layer and the intensity and wavelength of which is adjustable so that at an intensity I(+) the conduction electron density of an intermediate layer coupling has the algebraic sign which is appropriate for writing "1" and at an intensity I(-) the opposite algebraic sign of the coupling is effected for writing the "0" bit or deleting the information.

10. A magneto-optical storage system according to claim 9,
characterised in that
an arrangement is additionally provided for a magnetic field (Hₛ) extending perpendicularly to the plane of the layers, the field strength of which is designed so that it falls between the coercive field strengths (H_{c1} and H_{c2}) of the ferromagnetic layers to be coupled.

11. A magneto-optical storage system having a write head and a light source, a focus system and a storage layer,
characterised by
a magneto-optical storage layer system according to any one of claims 3 to 8, consisting of three ferromagnetic layers with a semiconducting layer situated therebetween in each case, and of two light sources, wherein one is focused on one intermediate layer and the other is focused on the other intermediate layer, and the intensity and wavelength of one light source is adjustable so that the conduction electrons of the respective semiconductor layer write information to the middle ferromagnetic layer, via the intermediate layer coupling, using one of the two ferromagnetic layers as a reference layer, and the intensity and wavelength of the other light source are adjustable so that the conduction electrons of the respective semiconductor layer delete the information again which is written to the intermediate layer, via the intermediate layer coupling, using the other ferromagnetic layer as a reference layer.

12. A magneto-optical writing procedure, in which the magneto-optical storage system according to any one of claims 9 to 11 is used and a (laser) photoflash is used for writing or deleting information,
characterised in that
the (laser) photoflash which is focused on a semiconducting layer does not exceed a duration of 10⁻⁹ seconds.

13. A magneto-optical writing procedure according to claim 12, using a storage layer system according to claim 7,
characterised in that
a (laser) photoflash is used of an intensity such that the lower spin half band of the conduction electron states is occupied by photoelectrons for the determination of the algebraic sign of the intermediate layer coupling and thereby of the write mode.

## Revendications

1. Système de couches de mémorisation magnéto-optique comportant une couche magnétique en tant que couche de mémorisation d'une information numérique,
caractérisé en ce que
il est prévu deux ou trois couches ferromagnétiques (FM 1, FM 2, FM 3) entre lesquelles se trouve respectivement une couche semiconductrice (HL, HLₐ, HL_{b}), les couches ferromagnétiques étant de duretés magnétiques différentes et l'épaisseur et la bande interdite des couches semiconductrices étant telles que, par un rayonnement focalisé d'une source lumineuse d'intensité et de longueur d'ondes adéquates, un nombre suffisant d'électrons excités par induction lumineuse soit excité dans les états de bande de conduction jusqu'ici vides du semiconducteur, ce qui provoque entre les couches ferromagnétiques voisines un couplage de couche intermédiaire du type RKKY, qui ne serait pas présent sans lumière et qui provoque une mémorisation ou un effacement de l'information dans l'une des couches ferromagnétiques.

2. Système à couches de mémorisation magnéto-optique suivant la revendication 1,
caractérisé en ce que
dans le cas où le système de couches comporte deux couches ferromagnétiques, la couche supérieure est magnétiquement plus douce que la couche inférieure.

3. Système de couches de mémorisation magnéto-optique suivant l'une des revendications 1 et 2,
caractérisé en ce que
dans le cas où le système de couches comporte trois couches ferromagnétiques, la couche du milieu est magnétisée de manière plus douce que les deux autres couches ferromagnétiques.

4. Système de couches de mémorisation magnéto-optique suivant l'une des revendications 1 à 3,
caractérisé en ce que
l'épaisseur totale des deux couches ferromagnétiques où, dans le cas où le système de couches comporte trois couches ferromagnétiques, des trois couches supérieures n'est pas supérieure à 20 nm.

5. Système de couches de mémorisation magnéto-optique suivant l'une des revendications 1 à 4,
caractérisé en ce que
la couche ferromagnétique supérieure est plus mince que celle se trouvant en dessous d'elle.

6. Système de couches de mémorisation magnéto-optique suivant l'une des revendications 1 à 5,
caractérisé en ce que l'épaisseur de la couche de semiconducteur est comprise entre 0,5 et 5 nm.

7. Système de couches de mémorisation magnéto-optique suivant l'une des revendications 1 à 6,
caractérisé en ce que
les couches semiconductrices sont en un matériau du groupe de semiconducteur magnétique EuX, (avec X = O, S, Se, Te).

8. Système de couches de mémorisation magnéto-optique suivant l'une des revendications 1 à 7,
caractérisé en ce que
le semiconducteur est dopé en donateurs pour la production de la bande interdite prescrite.

9. Système de mémorisation magnéto-optique comportant une tête d'écriture, une source de lumière, un système de focalisation et une couche de mémorisation,
caractérisé par
un système de couches de mémorisation magnéto-optique suivant l'une des revendications 1, 2 et 4 à 8, constitué de deux couches ferromagnétiques à couche intermédiaire, et d'une source lumineuse, qui est focalisée sur la couche intermédiaire et dont l'intensité et la longueur d'ondes peuvent être réglées de telle sorte que pour une intensité I(+) la densité d'électrons de conduction d'un couplage de couche intermédiaire a le signe correspondant à l'écriture du "1" et que pour une intensité (I-) le signe opposé du couplage soit provoqué pour l'écriture des bits "0" ou pour l'effacement de l'information.

10. Système de mémorisation magnéto-optique suivant la revendication 9,
caractérisé en ce que
il est prévu en supplément un dispositif pour produire un champ magnétique (H_{S}) s'étendant perpendiculairement au plan des couches, dont l'intensité du champ est telle qu'elle se trouve entre les intensités de champs coercitifs (H_{c1} et H_{c2}) des couches ferromagnétiques à coupler.

11. Système de mémorisation magnéto-optique comportant une tête d'écriture, une source lumineuse, un système de focalisation et une couche de mémorisation,
caractérisé par
un système de couches de mémorisation magnéto-optique suivant l'une des revendications 3 à 8, constitué de trois couches ferromagnétiques entre lesquelles se trouve respectivement une couche semiconductrice, et de deux sources lumineuses, l'une de ces sources étant focalisée sur l'une des couches intermédiaires et l'autre source étant focalisée sur l'autre couche intermédiaire, et l'intensité et la longueur d'ondes de l'une des sources de lumière pouvant être réglées de telle sorte que les électrons de conduction de la couche semiconductrice concernée écrivent, dans la couche ferromagnétique du milieu, des informations en exploitant l'une des deux couches ferromagnétiques en tant que couche de référence par l'intermédiaire du couplage de couche intermédiaire, et l'intensité et la longueur d'ondes de l'autre source lumineuse peuvent être réglées de telle sorte que les électrons de conduction de la couche semiconductrice concernée effacent de nouveau des informations écrites dans la couche intermédiaire en exploitant l'autre couche ferromagnétique en tant que couche de référence par l'intermédiaire du couplage de couche intermédiaire.

12. Procédé d'écriture magnéto-optique, dans lequel on utilise le système de mémorisation magnéto-optique suivant l'une des revendications 9 à Il et dans lequel on utilise un éclair de lumière (laser) pour écrire ou effacer des informations,
caractérisé en ce que
l'éclair de lumière (laser) focalisée sur une couche semiconductrice a une durée ne dépassant pas 10⁻⁹ s.

13. Procédé d'écriture magnéto-optique suivant la revendication 12 dans lequel on utilise un système de couches de mémorisation suivant la revendication 7,
caractérisé en ce que
on utilise un éclair de lumière (laser) d'une intensité telle que la demi-bande inférieure de spin des états des électrons de conduction soit occupée par des photoélectrons pour la fixation du signe du couplage de couche intermédiaire et donc du mode d'écriture.
